Europäisches Patentamt

European Patent Office

Office européen des brevets

(11) Publication number: **0 215 485 B1**

# EUROPEAN PATENT SPECIFICATION

(45) Date of publication of patent specification: **02.12.92** (51) Int. Cl.5: **G06F 11/20**

(21) Application number: **86112889.0**

(22) Date of filing: **18.09.86**

(54) Semiconductor memory device.

(30) Priority: **18.09.85 JP 205747/85**

(43) Date of publication of application:
**25.03.87 Bulletin 87/13**

(45) Publication of the grant of the patent:
**02.12.92 Bulletin 92/49**

(84) Designated Contracting States:
**DE FR GB**

(56) References cited:

IEEE JOURNAL OF SOLID-STATE CIRCUITS,
vol. SC-18, no. 5, October 1983, pages
544-550, IEEE, New York, US; M. YOSHIDA et
al.: "A 288K CMOS EPROM with redundancy"

PATENT ABSTRACTS OF JAPAN, vol. 7, no.
67 (P-184)[1212], 19th March 1983; & JP-A-57
210 500 (MITSUBISHI DENKI K.K.) 24-12-1982

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Saito, Shozo c/o Patent Division**
**Kabushiki Kaisha Toshiba 1-1 Shibaura**
**1-chome**
**Minato-ku Tokyo 105(JP)**
Inventor: **Fujii, Syuso c/o Patent Division**
**Kabushiki Kaisha Toshiba 1-1 Shibaura**
**1-chome**
**Minato-ku Tokyo 105(JP)**

(74) Representative: **Eitle, Werner, Dipl.-Ing. et al**
**Hoffmann, Eitle & Partner Patentanwälte Ar-**
**abellastrasse 4**
**W-8000 München 81(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

# Description

This invention relates to semiconductor memory devices with redundancy circuits, and more particularly to an improvement of programmable spare decoders in semiconductor memory devices.

In recent years, in semiconductor devices of a very high degree of integration, called "VLSI" (very large scale integration), with increase of integration density, the miniaturization of elements and the size increase of chips have been amazing. For this reason, the probability of a defective bit occurring in a semiconductor chip has become greater and the reduction of the manufacturing yield is present. In order to solve this problem, auxiliary decoders and spare bits are formed in the chip. Semiconductor integrated circuit devices have been developed in which, if there is a defective bit, it is replaced with a spare bit by means of an auxiliary decoder. These circuits are called "redundancy circuit". In order to replace the defective bit with a spare bit, the auxiliary decoder can be programmed so that the defective bit is disconnected from the device by a programmable fuse element, and the spare bit selected.

A 288K CMOS EPROM with a nine-block cell array is disclosed in IEEE Journal of solid state circuits, Vol. SC-18(1983) Oct. No. 5, New York, USA. The device can be used as an 8 or 9 bit EPROM of which the ninth block can be used as a redundant block by electrically programmable polysilicon fuses. To eliminate failures due to defective word lines a redundant circuit for word replacement is included (Figure 8). The defective word line is switched by replacing the decoder which drives the defective word line with a redundant decoder. In this case the fuse corresponding to the defective address bit $A_i$ and the fuse of the circuit to indicate enabling of the redundant word line are blown.

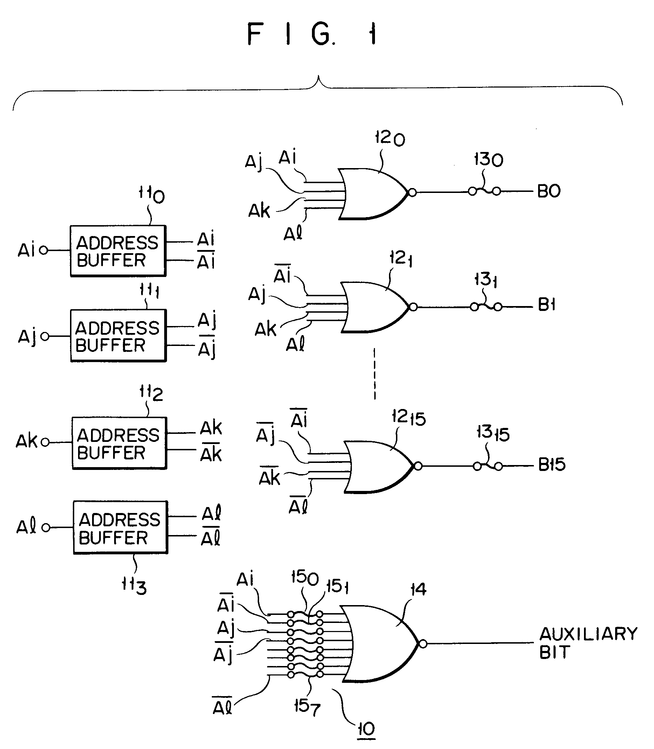

To give a more detailed description of the basic structure of such semiconductor memory devices Fig. 1 shows a buffer circuit, a main decoder circuit and a programmable spare decoder circuit in a MOS (metal oxide semiconductor) dynamic RAM (random access memory). Address buffers $11_0$, $11_1$, $11_2$, $11_3$ are provided to receive address inputs $A_i$, $A_j$, $A_k$ and $A_l$. Each of the address buffers $11_0$ to $11_3$ outputs two signals, one in phase with its input signal, and the other out of phase, i.e. a complementary signal. Main decoders are composed of NOR circuits $12_0$ to $12_{15}$, which receive different combinations of two signals output from buffers $11_0$ to $11_3$.

One of the decoders $12_0$ to $12_{15}$ is energized according to the logic of the address input, and the energized decoder energizes that of the bit lines $B_0$ to $B_{15}$ which is connected to the energized decoder. For example, if a defective bit is detected in the bit line $B_0$ connected to decoder $12_0$ according to a known method, fuse $13_0$ between decoder $12_0$ and bit line $B_0$ is opened or burned according to a relevant known method to disconnect decoder $12_0$ from the memory. The spare decoder 10 is comprised of fuses $15_0$ to $15_7$ coupled with all outputs $A_i$, $\overline{A_i}$ to $A_l$, $\overline{A_l}$ of address buffers $11_0$ to $11_3$ and a NOR circuit 14 coupled with those fuses. Spare decoder 10 designates an auxiliary or spare bit to repair the defective bit. To designate the auxiliary bit, it is necessary to program spare decoder 10 so that the logic of the spare decoder 10 be equal to that of the main decoder connected to the defective bit. This can be attained by selectively opening fuses $15_0$ to $15_7$ so as to have the same program. In this case, the number of fuses to be opended is the half of the buffer outputs $A_i$, $\overline{A_i}$ to $A_l$, $\overline{A_l}$.

In recent years, a laser has been used for opening or buring these fuse elements. Accuracy of opening operation is relatively improved, but is still insufficient. The number of opening errors increases as the number of fuses to be opening is large. Therefore, decrease of the number of the burned fuses leads to improvement of repairing accuracy of defective element.

The main decoders $12_0$ to $12_{15}$ used in the conventional MOS dynamic RAM are constructed with NOR circuits. In all of these NOR circuits, in a precharge mode, their output nodes are precharded to logical high level. In an active mode, nodes other than a selected node are discharged to logical low level. The discharge of the non-select nodes consumes much power. Reduction of the power dissipation is a strong demand in this field.

Accordingly, an object of this invention is to provide a semiconductor device which can effectively repair defective bits with low power dissipation by reducing the number of fuse elements.

According to an aspect of this invention, there is provided a semiconductor memory device with a redundancy circuit comprising: address buffers each receiving an address signal and producing a signal in phase with the address signal and a signal out of phase with the address signal; partial decoders comprising logic circuits for receiving different combinations of the signals supplied from said address buffers and producing output signals; main decoders comprising logic circuits and fuse elements connected to the logic circuits, for receiving different combinations of the signals supplied from said partial decoders and producing output signals to select a bit designated by the address signals, a fuse element of a main decoder being opened or burnt to disconnect the main decoder from the memory if the defective bit is detected in the respective bit line; and a programmable decoder (30) comprising programming fuse circuits and a NOR-gate, the programmable decoder being programmed by opening fuse elements of the programming fuse circuits to have the same program as that of the main decoder being disconnected from the memory, so that when said defective bit is designated by the address signals, the programmable decoder selects a spare bit; characterized in that said programmable decoder, receives the output signals from said partial decoders so that when a bit selected by said main decoders is defective said programmable decoder selects the spare bit based on the program applied to said programmable decoder.

According to another aspect of this invention, there is provided a semiconductor memory device with a redundancy circuit comprising: address buffers each receiving an address signal and producing a signal in phase with the address signal and a signal out of phase with the address signal; partial decoders comprising logic circuits for receiving different combinations of the signals supplied from said address buffers and producing output signals; main decoders comprising logic circuits for receiving different combinations of the signals supplied from said first partial decoders and producing output signals; fuse elements receiving the signals supplied from said main decoders and producing output signals to select a bit, designated by the address signals, a fuse element being opened or burnt to disconnect the main decoder from the memory if a defective bit is detected in the respective bit line; and a programmable decoder comprising programming fuse circuits and a NOR-gate, the programmable decoder being programmed by opening fuse elements of the programming fuse circuits to have the same program as the of the main decoder being disconnected from the memory, so that when said defective bit is designated by the address signals, the programmable decoder selects a spare bit; characterized in that said programmable decoder, receives the output signals from said main decoders so that when a bit selected by said main decoders is defective said programmable decoder selects the spare bit based on the program applied to said programmable decoder.

According to a further aspect of this invention there is provided a semiconductor memory device with a redundancy circuit comprising: address buffers each receiving an address signal and producing a signal in phase with the address signal and a signal out of phase with the address signal: a plurality of stages of partial decoders the partial decoders of the first stage comprising logic circuits for receiving different combinations of the signals supplied from said address buffers and producing output signals, the partial decoders of the second and the following stages each comprising logic circuits for receiving different combinations of the signals supplied from the partial decoders of the preceding stage and producing output signals to the partial decoders of the following stage; fuse elements for receiving the signals supplied from the partial decoders of the final stage and producing output signals to select a bit designated by the address signals, a fuse element being opened or burnt to disconnect the partial decoders of the final stage from the memory if the defective bit is detected in the respective bit line; and a programmable decoder comprising programming fuse circuits the programmable decoder being programmed by opening a fuse element of the programming fuse circuits to have the same program as that of the partial decoders of the final stage being disconnected from the memory, so that when said defective bit is designated by the address signals, the programmable decoder selects a spare bit; characterized in that said programmable decoder receives the output signals from the partial decoders of the final stage so that when a bit selected by said partial decoders of the final stage is defective said programmable decoder selects the spare bit based on the program applied to said programmable decoder.

This invention can be more fully understood from the following detailed description whent aken in conjunction with the accompanying drawings, in which:

Fig. 1 is a logic circuit diagram showing one example of prior semiconductor devices;
Fig. 2 is a logic circuit diagram of a semiconductor device according to an embodiment of this invention; and
Fig. 3 is a logic circuit diagram of a semiconductor device according to another embodiment of this invention.

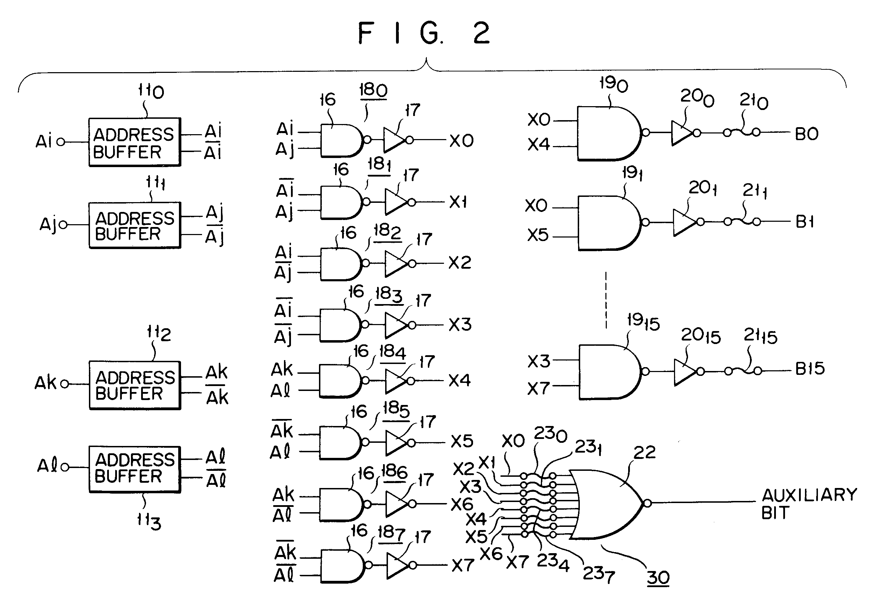

An embodiment of this invention will be described referring to Fig. 2. In this embodiment, only four address inputs Ai, Aj, Ak and Aℓ are provided for simplicity of explanation. Four address buffers $11_0$ to $11_3$ are provided for receiving address inputs Ai, Aj, Ak and Aℓ, respectively. These buffers output signals that are in phase with their inputs and signals that are out of phase, i.e., complementary signals. Partial decoders $18_0$ to $18_7$ are each composed of a NAND circuit 16 and an inverter 17 connected to the output of the NAND circuit. Different paired signals or different combination of signals output from buffers $11_0$ to $11_3$ are supplied to these NAND circuits as the input signals. Different paired signals of outputs X0 - X7 of partial decoders $18_0$ to $18_7$ are input to main decoders $19_0$ to $19_{15}$, which are composed of NAND circuits. For example, if a defective bit is detected in the bit line B0 connected to decoder $19_0$ according to a known method, fuse $21_0$ between decoder $19_0$ and

bit line B0 is opened or burned according to the relevant known method to disconnect decoder $19_0$ from the memory. The spare decoder 30 is comprised of programming fuses $23_0$ to $23_7$ coupled with all outputs of the partial decoders $18_0$ to $18_7$ coupled with those fuses. Spare decoder 30 designates an auxiliary or spare bit to repair the defective bit. To designate the auxiliary bit, it is necessary to program spare decoder 30 so that the logic of the spare decoder 30 be equal to that of the main decoder connected to the defective bit. This can be attained by opening only two fuses $23_0$ and $23_4$ of those $23_0$ to $23_7$. The fuses $23_0$ and $23_4$ are coupled with signals, which are input to NAND circuit $19_0$ as the main decoder. Thus, opening of only two fuses of those eight fuses is merely needed for programming in this embodiment, while prior art needs the opening of the half of all of the fuses. That is to say, the number of opened fuses may be reduced 1/2 that of the prior art. In this respect, the opening error occurrence is remarkably reduced in this embodiment.

NAND circuits are used for the main decoders $19_0$ to $19_{15}$. Therefore, in the active mode, only the output node of the selected decoder or the bit line connected to the selected decoder is discharged. The output nodes of the remaining decoders are left in the precharged state, i.e. logical high level. As a result, the power dissipation can be reduced.

In the decoder of this embodiment, although the number of required fuses is equal to that of the prior decoder, the number of opened fuse elements is reduced half. In this respect, repairment of defective bits by the redundancy circuit can greatly be improved.

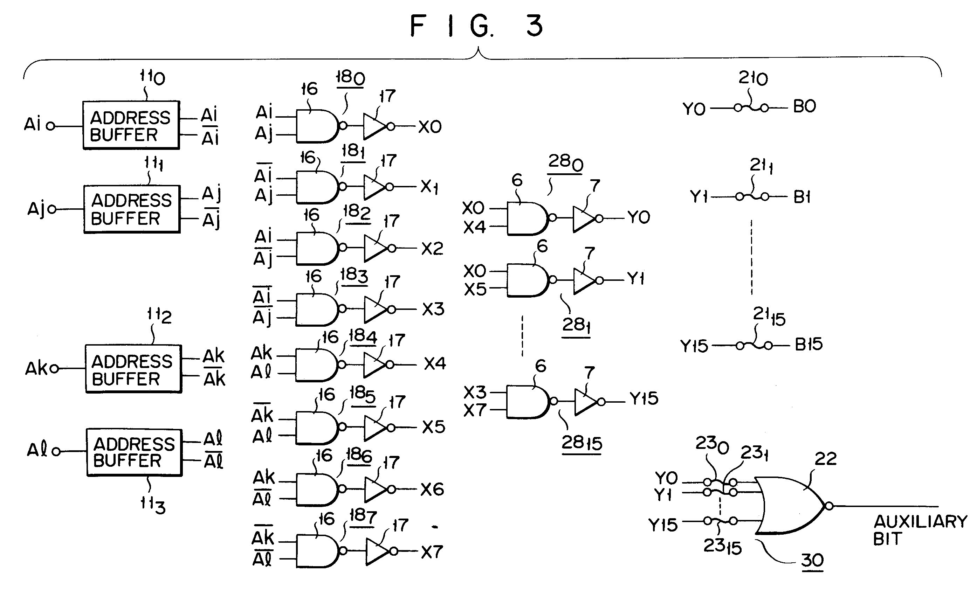

Alternatively, second partial decoders are used, which are connected to the outputs of the partial decoders $18_0$-$18_7$. The outputs of the second partial decoders are supplied to spare decoder 30 via programming fuses $23_0$ to $23_3$ of spare decoder 30. Such an approach is implemented in Fig. 3. In Fig. 3, same reference numerals are used for designating same equivalent portions in Fig. 2. As shown, in this embodiment, second partial decoders $28_0$ to $28_{15}$ each comprising a NAND gate 6 and an inverter 7 are provided. Applied to second partial decoders $28_0$ to $28_{15}$ are different pairs of outputs X0 to X7 issued from the first partial decoders $18_0$-$18_7$. The outputs Y0 to Y15 of second decoders $28_0$ to $28_{15}$ are input to spare decoder 30 via programming fuses $23_0$ to $23_{15}$.

For example, if a defective bit is detected in the bit line B0 connected to fuse $21_0$ as a main decoder according to the known method, fuse $21_0$ connected to bit line B0 is opened according to a relevant known method to disconnect the output Y0 from the memory. The spare decoder 30 is comprised of fuses $23_0$ to $23_{15}$ coupled with all outputs Y0 - Y15 of the second partial decoders $28_0$ to $28_{15}$, and a NOR circuit 22 coupled with those fuses. Spare decoder 30 designates an auxiliary or spare bit to repair the defective bit. To designate the auxiliary bit, it is necessary to program spare decoder 30 so that the logic of the spare decoder 30 be equal to that of the main decoder connected to the defective bit. This can be attained by opening only one fuse $23_0$ of those $23_0$ to $23_{15}$. The fuse $23_0$ is coupled with the signal Y0, which is input to the fuse $21_0$ as the main decoder. Thus, in this embodiment, the opening of the one fuse is needed for programming, while the prior art needs the opening of the half of all of the fuses. That is to say, the number of open fuses may be reduced 1/4 that of the prior art. In this respect, the opening error occurrence is remarkable reduced in this embodiment.

As described above, in this embodiment, no NAND circuits are used for she main decoders. Therefore, the charge or discharge does not occur. As the result, the power dissipation can be reduced.

It should be understood that the number of partial decoder stages is not limited to one or two stages, but if necessary a desired number of the decoder stages may be used. The number of fuses to be opened is reduced $1/2^n$ that of the prior device shown in Fig. 1 (n is the number of stages of partial decoder).

As will clearly be understood form the above, according to the invention, the production yield can be increased and the power dissipation can be reduced.

## Claims

1. A semiconductor memory device with a redundancy circuit comprising:

   address buffers ($11_0$, ..., $11_3$) each receiving an address signal (Ai, ..., Al) and producing a signal in phase with the address signal and a signal out of phase with the address signal;

   partial decoders ($18_0$, ..., $18_7$) comprising logic circuits (16, 17) for receiving different combinations of the signals supplied from said address buffers and producing output signals ($X_0$, ..., $X_7$);

   main decoders comprising logic circuits ($19_0$, $20_0$, ..., $19_{15}$, $20_{15}$) and fuse elements ($21_0$, ..., $21_{15}$) connected to the logic circuits, for receiving different combinations of the signals supplied from said partial decoders and producing output signals to select a bit (B0, ..., B15) designated by the address signals, a fuse element of a main decoder being opened or burnt to disconnect the main decoder from the memory if the defective bit is detected in the respective bit line; and

a programmable decoder (30) comprising programming fuse circuits ($23_0$, ..., $23_7$,) and a NOR-gate (22), the programmable decoder being programmed by opening fuse elements ($23_0$, ..., $23_7$) of the programming fuse circuits to have the same program as that of the main decoder being disconnected from the memory, so that when said defective bit is designated by the address signals the programmable decoder selects a spare bit;

**characterized** in that:

said programmable decoder receives the output signals from said partial decoders so that when a bit selected by said main decoders is defective said programmable decoder selects the spare bit based on the program applied to said programmable decoder.

2. A semiconductor memory device according to claim 1,
**characterized** in that
said logic circuits of said partial decoders are NAND gates.

3. A semiconductor memory device according to claims 1 or 2,
**characterized** in that
said logic circuit of said main decoders are NAND gates.

4. A semiconductor memory device with a redundancy circuit comprising:

address buffers ($11_0$, ..., $11_3$) each receiving an address signal (Ai, ..., Al) and producing a signal in phase with the address signal and a signal out of phase with the address signal;

partial decoders ($18_0$, ..., $18_7$) comprising logic circuits (16, 17) for receiving different combinations of the signals supplied from said address buffers and producing output signals ($X_0$, ..., $X_7$);

main decoders ($28_0$, ..., $28_{15}$) comprising logic circuits (6, 7) for receiving different combinations of the signals supplied from said first partial decoders and producing output signals (Y0, ..., Y15);

fuse elements ($21_0$, ..., $21_{15}$) receiving the sig-

nals supplied from said main decoders and producing output signals to select a bit (B0, ..., B15) designated by the address signals, a fuse element being opened or burnt to disconnect the main decoder from the memory if a defective bit is detected in the respective bit line; and

a programmable decoder (30) comprising programming fuse circuits ($23_0$, ..., $23_{15}$,) and a NOR-gate (22), the programmable decoder being programmed by opening fuse elements ($23_0$, ..., $23_{15}$) of the programming fuse circuits to have the same program as the of the main decoder being disconnected from the memory, so that when said defective bit is designated by the address signals, the programmable decoder selects a spare bit;

**characterized** in that

said programmable decoder receives the output signals from said main decoders so that when a bit selected by said main decoders is defective said programmable decoder selects the spare bit based on the program applied to said programmable decoder.

5. A semiconductir memory device according to claim 4,
**characterized** in that
said logic circuits of said partial and main decoders are NAND gates.

6. A semiconductor memory device with a redundancy circuit comprising:

address buffers ($11_0$, ... $11_3$) each receiving an address signal (Ai, ... Al) and producing a signal in phase with the address signal and a signal out of phase with the address signal;

a plurality of stages of partial decoders ($18_0$, ..., $18_7$; $28_0$, ..., $28_{15}$), the partial decoders ($18_0$, ..., $18_7$) of the first stage comprising logic circuits (16, 17) for receiving different combinations of the signals supplied from said address buffers and producing output signals ($X_0$, ..., $X_7$), the partial decoders ($28_0$, ..., $28_{15}$) of the second and the following stages each comprising logic circuits (6, 7) for receiving different combinations of the signals supplied from the partial decoders of the preceding stage and producing output signals (Yo, ..., Y15) to the partial decoders of the following stage;

fuse elements ($21_0$, ..., $21_{15}$) for receiving the

signals supplied from the partial decoders of the final stage and producing output signals to select a bit (B0, ..., B15) designated by the address signals, a fuse element being opened or burnt to disconnect the partial decoders of the final stage from the memory if the defective bit is detected in the respective bit line; and

a programmable decoder (30) comprising programming fuse circuits ($23_0$, ..., $23_{15}$) and a NOR-gate (22) the programmable decoder being programmed by opening a fuse element of the programming fuse circuits to have the same program as that of the partial decoders of the final stage being disconnected from the memory, so that when said defective bit is designated by the address signals, the programmable decoder selects a spare bit;

**characterized** in that

said programmable decoder, receives the output signals from the partial decoders of the final stage so that when a bit selected by said partial decoders of the final stage is defective said programmable decoder selects the spare bit based on the program applied to said programmable decoder.

7. A semiconductor memory device according to claim 6,
**characterized** in that
said logic circuits of said partial decoders are NAND gates.

**Patentansprüche**

1. Halbleiterspeichervorrichtung mit einem Redundanzschaltkreis enthaltend:

Adresspuffer ($11_0$, ..., $11_3$), von denen jeder ein Adressignal (Ai, ... Al) empfängt, und ein Signal in Phase mit dem Adressignal und ein Signal ausser Phase mit dem Adressignal erzeugt;

Teildekodierer ($18_0$, ... $18_7$), umfassend Logikschaltkreise (16, 17) zum Empfangen unterschiedlicher Kombinationen der Signale, zugeführt von den Adresspuffern, und zum Erzeugen von Ausgangssignalen ($X_0$, ... $X_7$);

Hauptdekodierern umfassend Logikschaltkreise ($19_0$, $20_7$, ... $19_{15}$, $20_{15}$) und Sicherungselemente ($21_0$, ... $21_{15}$), angeschlossen an die Logikschaltkreise, zum Empfangen unterschiedlicher Kombinationen der Signale, zugeführt von den Teildekodierern und zum Erzeugen von Ausgangssignalen, um ein Bit (B0, ..., B15) zu selektieren, bezeichnet durch die Adressignale, wobei ein Sicherungselement eines Hauptdekodierers geöffnet oder durchgebrannt wird, um den Hauptdekodierer von dem Speicher zu trennen, falls das defekte Bit in der betreffenden Bitleitung detektiert wird; und

einen programmierbaren Dekodierer (30) umfassend programmierende Sicherungsschaltkreise ($23_0$, ... $23_7$) und ein NOR-Gatter (22), wobei der programmierbare Dekodierer programmiert wird durch Öffnen von Sicherungselementen ($23_0$, ... $23_7$) des programmierenden Sicherungsschaltkreises, um dasselbe Programm wie das des Hauptdekodierers zu haben, der von dem Speicher getrennt wird, so daß, wenn das defekte Bit durch die Adressignale bezeichnet wird, der programmierbare Dekodierer ein Ersatzbit selektiert;

dadurch **gekennzeichnet,** daß

der programmierbare Dekodierer die Ausgangssignale von den Teildekodierern empfängt, so daß, wenn ein durch die Hauptdekodierer selektiertes Bit defekt ist, der programmierbare Dekoder das Ersatzbit, basierend auf dem den programmierbaren Dekodierer zugefügten Programm selektiert.

2. Halbleiterspeichervorrichtung nach Anspruch 1, dadurch **gekennzeichnet,**
daß die Logikschaltkreise der Teildekodierer NAND-Gatter sind.

3. Halbleiterspeichervorrichtung nach Anspruch 1 oder 2, dadurch **gekennzeichnet,** daß
die Logikschaltkreise der Hauptdekodierer NAND-Gatter sind.

4. Halbleiterspeichervorrichtung mit einem Redundanzschaltkreis enthaltend:

Adresspuffer ($11_0$, ... $11_3$), von denen jeder ein Adressignal (Ai, ... Al) empfängt, und ein Signal in Phase mit dem Adressignal und ein Signal ausser Phase mit dem Adressignal erzeugt;

Teildekodierer ($18_0$, ... $18_7$), umfassend Logikschaltkreise (16, 17) zum Empfangen unterschiedlicher Kombinationen der Signale, zugeführt von den Adresspuffern, und zum Erzeugen von Ausgangssignalen (X0, ... X7);

Hauptdekodierern ($28_0$, ... $28_{15}$) umfassend Logikschaltkreise (6, 7) zum Empfangen unterschiedlicher Kombinationen der Signale, zugeführt von den ersten Teildekodierern und zum Erzeugen von Ausgangssignalen (Y0, ... Y15); Sicherungselemente ($21_0$, ..., $21_{15}$) empfangend die Signale, zugeführt von den Hauptdekodierern, und erzeugend Ausgangssignale, um ein Bit (B0,..., B15) zu selektieren, bezeichnet durch die Adressignale, wobei ein Sicherungselement geöffnet oder durchgebrannt wird, um den Hauptdekodierer von dem Speicher zu trennen, falls das defekte Bit in der betreffenden Bitleitung detektiert wird; und

einen programmierbaren Dekodierer (30) umfassend programmierende Sicherungsschaltkreise ($23_0$, ... $23_{15}$) und ein NOR-Gatter (22), wobei der programmierbare Dekodierer programmiert wird durch Öffnen von Sicherungselementen ($23_0$, ... $23_{15}$) des programmierenden Sicherungsschaltkreises, um dasselbe Programm wie das des Hauptdekodierers zu haben, der von dem Speicher getrennt wird, so daß , wenn das defekte Bit durch die Adressignale bezeichnet wird, der programmierbare Dekodierer ein Ersatzbit selektiert;

dadurch **gekennzeichnet,** daß

der programmierbare Dekodierer die Ausgangssignale von den Hauptdekodierern empfängt, so daß, wenn ein durch die Hauptdekodierer selektiertes Bit defekt ist, der programmierbare Dekoder das Ersatzbit, basierend auf dem den programmierbaren Dekodierer zugeführten Programm selektiert.

5. Halbleiterspeichervorrichtung nach Anspruch 4, dadurch **gekennzeichnet,** daß die Logikschaltkreise der Teil- und Hauptdekodierer NAND-Gatter sind.

6. Halbleiterspeichervorrichtung mit einem Redundanzschaltkreis enthaltend:

Aresspuffer ($11_0$, ..., $11_3$), von denen jeder ein Adressignal (Ai, ... Al) empfängt und ein Signal in Phase mit dem Adressignal und ein Signal ausser Phase mit dem Adressignal erzeugt;

eine Vielzahl von Stufen aus Teildekodierern ($18_0$, ..., $18_7$; $28_0$, ..., $28_{15}$) , wobei die Teildekodierer ($18_0$, ... $18_7$) der ersten Stufe umfassen Logikschaltkreise (16, 17) zum Empfangen unterschiedlicher Kombinationen der Signale, zugeführt von den Adresspuffern und zum Erzeugen von Ausgangssignalen ($X_0$, ... $X_7$) ,

wobei die Teildekodierer ($28_0$, ... $28_{15}$) der zweiten und der folgenden Stufen jeweils umfassen Logikschaltkreise (6, 7) zum Empfangen unterschiedlicher Kombinationen der Signale, zugeführt von den Teildekodiern der vorangegangenen Stufe, und zum Erzeugen von Ausgangssignalen ($Y_0$, ..., $Y_{15}$) an die Teildekodierer der folgenden Stufe;

Sicherungselemente ($21_1$, ... $21_{15}$) zum Empfangen der Signale, zugeführt von den Teildekodierern der letzten Stufe, und zum Erzeugen von Ausgangssignalen, um ein durch die Adressignale bezeichnetes Bit ($B_0$, ... $B_{15}$) zu selektieren, wobei ein Sicherungselement geöffnet oder durchgebrannt wird, um die Teildekodierer der ersten Stufe von dem Speicher zu trennen, falls das defekte Bit in der jeweiligen Bitleitung detektiert wird; und

ein programmierbarer Dekodierer (30) umfassend programmierende Sicherungsschaltkreise ($23_0$, ... $23_{15}$) und ein NOR-Gatter (22), wobei der programmierbare Dekodierer durch Öffnen eines Sicherungselements der programmierenden Sicherungsschaltkreise programmiert wird, um dasselbe Programm wie das der von dem Speicher getrennten Teildekodierern der letzten Stufe zu haben, so daß, wenn das defekte Bit durch die Adressignale bezeichnet wird, der programmierbare Dekodierer ein Ersatzbit selektiert,

dadurch **gekennzeichnet,** daß

der programmierbare Dekodierer die Ausgangssignale der Teildekodierer der letzten Stufe empfängt, so daß, wenn ein durch die Teildekodierer der letzten Stufe selektiertes Bit defekt ist, der programmierbare Dekodierer das Ersatzbit, basierend auf dem Programm, das dem programmierbaren Dekodierer zugeführt wurde, selektiert.

7. Halbleiterspeichervorrichtung nach Anspruch 6, dadurch **gekennzeichnet,** daß die Logikschaltkreise der Teildekodierer NAND-Gatter sind.

**Revendications**

1. Dispositif de mémoire à semiconducteur muni d'un circuit de redondance comprenant :
des tampons d'adresse ($11_0$, ..., $11_3$), chacun recevant un signal d'adresse (Ai, ..., Al) et produisant un signal en phase avec le signal d'adresse et un signal déphasé par rapport au signal d'adresse ;

des décodeurs partiels ($18_0$, ..., $18_7$) comprenant des circuits logiques (16, 17) pour recevoir différentes combinaisons des signaux appliqués à partir desdits tampons d'adresse et pour produire des signaux de sortie ($X_0$, ..., $X_7$) ;

des décodeurs principaux comprenant des circuits logiques ($19_0$, $20_0$,..., $19_{15}$, $20_{15}$) et des éléments de fusible ($21_0$, ..., $21_{15}$) connectés aux circuits logiques, pour recevoir différentes combinaisons des signaux appliqués à partir desdits décodeurs partiels et pour produire des signaux de sortie afin de sélectionner un bit (B0,...., B15) indiqué par les signaux d'adresse, un élément de fusible d'un décodeur principal étant ouvert ou grillé pour déconnecter le décodeur principal de la mémoire si le bit défectueux est détecté dans la ligne de bit respective.; et

un décodeur programmable (30) comprenant des circuits de fusible de programmation ($23_0$, ...., $23_7$) et une porte NON-OU (22), le décodeur programmable étant programmé par l'ouverture d'éléments de fusible ($23_0$, ..., $23_7$) des circuits de fusible de programmation afin que le même programme que celui du décodeur principal soit déconnecté de la mémoire de telle sorte que lorsque ledit bit défectueux est indiqué par les signaux d'adresse, le décodeur programmable sélectionne un bit de réserve ;

caractérisé en ce que :

ledit décodeur programmable reçoit les signaux de sortie en provenance desdits décodeurs partiels de telle sorte que lorsqu'un bit sélectionné par lesdits décodeurs principaux est défectueux, ledit décodeur programmable sélectionne le bit de réserve sur la base du programme appliqué auxdits décodeurs programmables.

2. Dispositif de mémoire à semiconducteur selon la revendication 1, caractérisé en ce que lesdits circuits logiques desdits décodeurs partiels sont des portes NON-ET.

3. Dispositif de mémoire à semiconducteur selon la revendication 1 ou 2, caractérisé en ce que lesdits circuits logiques desdits décodeurs principaux est une porte NON-ET.

4. Dispositif de mémoire à semiconducteur muni d'un circuit de redondance comprenant :

des tampons d'adresse ($11_0$, ..., $11_3$), chacun recevant un signal d'adressa (Ai, ..., Al) et produisant un signal en phase avec le signal d'adresse et un signal déphasé par rapport au signal d'adresse ;

des décodeurs parties ($18_0$, ..., $18_7$) comprenant des circuits logiques (16, 17) pour recevoir différentes combinaisons des signaux appliqués à partir desdits tampons d'adresse et pour produire des signaux de sortie ($X_0$, ..., $X_7$) ;

des décodeurs principaux ($28_0$,...., $28_{15}$) comprenant des circuits logiques (6, 7) pour recevoir différentes combinaisons des signaux appliqués depuis lesdits premiers décodeurs parties et pour produire des signaux de sortie (Y0, ..., Y15) ;

des éléments de fusible ($21_0$, ...., $21_{15}$) qui reçoivent les signaux appliqués depuis lesdits décodeurs principaux et qui produisent des signaux de sortie afin de sélectionner un bit (B0, ..., B15) indiqué par les signaux d'adresse, un élément de fusible étant ouvert ou grillé pour déconnecter le décodeur principal de la mémoire si un bit défectueux est détecté dans la ligne de bit respective ; et

un décodeur programmable (30) comprenant des circuits de fusible de programmation ($23_0$, ..., $23_{15}$) et une porte NON-OU (22), le décodeur programmable étant programmé par l'ouverture d'éléments de fusible ($23_0$, ..., $23_{15}$) des circuits de fusible de programmation afin que le même programme que celui du décodeur principal soit déconnecté de la mémoire de telle sorte que lorsque ledit bit défectueux est indiqué par les signaux d'adresse, le décodeur programmable sélectionne un bit de réserve ;

caractérisé en ce que ledit décodeur programmable reçoit les signaux de sortie en provenance desdits décodeurs principaux de telle sorte que lorsqu'un bit sélectionné par lesdits décodeurs principaux est défectueux, ledit décodeur programmable sélectionne le bit de réserve sur la base du programme appliqué audit décodeur programmable.

5. Dispositif de mémoire à semiconducteur selon la revendication 4, caractérisé en ce que lesdits circuits logiques desdits décodeurs parties et principaux sont des portes NON-ET.

6. Dispositif de mémoire à semiconducteur muni d'un circuit de redondance comprenant :

des tampons d'adresse ($11_0$, ..., $11_3$), chacun recevant un signal d'adresse (Ai, ..., Al) et produisant un signal en phase avec le signal d'adresse et un signal déphasé par rapport au signal d'adresse ;

une pluralité d'étages de décodeurs parties ($18_0$, ..., $18_7$ ; $28_0$,..., $28_{15}$), les décodeurs parties ($18_0$, ..., $18_7$) du premier étage comprenant des circuits logiques (16, 17) pour recevoir différentes combinaisons des signaux appliqués depuis lesdits tampons d'adresse et pour produire des signaux de sortie ($X_0$, ..., $X_7$), les décodeurs partiels ($28_0$, ..., $28_{15}$) du second étage et des étages suivants comprenant chacun des circuits logiques (6, 7) pour recevoir différentes combinaisons des signaux appliqués depuis les décodeurs partiels de l'étage précédent et pour produire des signaux de sortie (Y0,..., Y15) pour les décodeurs parties de l'étage suivant ;

des éléments de fusible ($21_0$, ..., $21_{15}$) pour recevoir les signaux appliqués depuis les décodeurs partiels de l'étage final et pour produire des signaux de sortie afin de sélectionner un bit (B0, ..., B15) indiqué par les signaux d'adresse, un élément de fusible étant ouvert ou grillé afin de déconnecter les décodeurs parties de l'étage final de la mémoire si le bit défectueux est détecté dans la ligne de bit respective ; et

un décodeur programmable (30) comprenant des circuits de fusible de programmation ($23_0$, ...., $23_{15}$) et une porte NON-OU (22), le décodeur programmable étant programmé par l'ouverture d'un élément de fusible des circuits de fusible de programmation afin que le même programme que celui du décodeur principal soit déconnecté de la mémoire de telle sorte que lorsque ledit bit défectueux est indiqué par les signaux d'adresse, le décodeur programmable sélectionne un bit de réserve ;

caractérisé en ce que ledit décodeur programmable reçoit les signaux de sortie en provenance des décodeurs parties des l'étage final de telle sorte que lorsqu'un bit sélectionné par lesdits décodeurs partiels de l'étage final est défectueux, ledit décodeur programmable sélectionne le bit de réserve sur la base du programme appliqué audit décodeur programmable.

7. Dispositif de mémoire à semiconducteur selon la revendication 6, caractérisé en ce que lesdits circuits logiques desdits décodeurs partiels sont des portes NON-ET.

# F I G. 1

# F I G. 2

F I G. 3